# EUROPEAN PATENT SPECIFICATION

(11) **EP 1 529 421 B1**
(45) Date of publication and mention of the grant of the patent: **02.03.2011**
(21) Application number: 03784786.0
(22) Date of filing: 18.07.2003
(51) Int. Cl.: H05K 7/16, H04B 1/38

(54) **TRACK SYSTEM FOR TELECOMMUNICATIONS TRANSMISSION STATIONS**
SCHIENENSYSTEM FÜR MOBILFUNK BASISSTATIONEN
SYSTEME DE SUIVI POUR DES STATIONS DE TRANSMISSION DE TELECOMMUNICATION

(30) Priority: 08.08.2002 US 402486 P; 31.01.2003 US 355992
(43) Date of publication of application: 11.05.2005
(73) Proprietor: Powerwave Technologies, Inc., Santa Ana, CA 92705 (US)
(72) Inventor: FLYNN, Michael, MPF Technologies, Inc., Santa Ana, CA 92705 (US)
(74) Representative: Philipp, Matthias
(86) International application number: PCT/US2003/022640
(87) International publication number: WO 2004/016057

(56) References cited:
- US-A- 2 885 600
- US-A- 4 694 484

## Description

### FIELD OF THE INVENTION

The present invention relates generally to transmission station installations for wireless telecommunications networks and, more particular, to track systems and methods of use that facilitate the optimization of transmission station site space.

### BACKGROUND OF THE INVENTION

Public demand for wireless telecommunications has grown at a tremendous rate. An increasing number of people rely on their wireless phones for an increasing number of uses including voice, messaging, data, video, and internet access. This enormous public demand has in turn fueled the need for additional carrier antenna sites to provide expanded wireless coverage to communities. As the need for additional antenna sites has grown, so too has the need for transmission capacity.

Cell phone carriers typically place their transceiver and other electronic and environmental control equipment in a self-contained cabinet, commonly referred to as a base transceiver station ("BTS"), on property, such as building roof tops, parking lots, and the like, that is leased from private owners and/or municipalities. The lease is typically for a specific amount of space or square footage to accommodate the footprint necessary for the installation of one or more BTS cabinets and clearance for maintenance or repair of the electronic equipment housed in a BTS cabinet. Typical BTS units are quite large and require a clearance of generally about three or four feet to allow the technician to open the cabinet doors and access the equipment within the BTS unit.

Because of the need for clearance for repair or maintenance, the addition of more BTS units to an installation to support an increase in transmission capacity typically requires an increase in installation space or foot print beyond the associated lease area. This can be problematic and inconvenient for the carrier who, as a result of the increased installation footprint, must renegotiate the lease for the installation and reapply for permits for the installation.

Further, as lease space becomes less available, more costly and fraught with stricter planning restrictions, the need to increase the transmission capacity of typical transmission stations becomes more problematic for the carriers. Larger installation footprints tend to be cost prohibitive, while taller installations tend to often be prohibitive by zoning laws.

Thus, it would be desirable to optimize the transmission capacity of a transmission station installation or to be able to increase the transmission capacity of a transmission station installation without increasing the installation space requirements or associated lease space.

US 5,443,312 discloses a rack assembly that securely accommodates a stack of assorted electronic or modular units therein, so that the entire rack assembly is extensible along a detachable service stand.

US 4,911,507 describes an anti-tip mobile storage system for movably supporting at least one mobile storage unit.

JP 11-20913 refers to a moving rack unit to enable a cable suppport lanyard to be laid by movably engaging a trolley for suspending a power supply cable between racks.

### SUMMARY OF THE INVENTION

The present invention is directed to a method and an apparatus that facilitate the optimization of the leased area space for an antenna and transmission or transceiver station installation site. In one aspect of the present invention, an installation site comprising a track system is provided that advantageously minimizes lease area space requirements for transceiver station installations with increased transmission capacity and enables the installation of more transceiver units or cabinets, such as base transceiver stations (BTS), radio base stations (RBS) and the like, in the same amount of space previously required for fewer transceiver units or cabinets. As a result, installation footprints can be custom designed to meet difficult space constraints and additional transceiver cabinets and cabinets housing other electronic equipment may be installed on existing installation footprints without increasing the leased area's space requirement and renegotiating the lease.
In a preferred embodiment, the track system preferably comprises one or more sets of parallelly spaced tracks, preferably formed of steel, having a predetermined length and spacing to accommodate a desired cabinet installation configuration. The tracks may be mounted on a base formed of steel or the like, to form an easily installable and configurable modular rack. As such, one or more transceiver units may be moveably mounted on the tracks side-to-side, front-to-front, back-to-back, and/or front-to-back. Preferably, the tracks include a ramp at the ends to enable the transceiver units to be installed on the tracks, a guide track along which a wheel, slide, follower or the like, coupled to the transceiver unit may travel, and an anti-tip track along which an anti-tip arm, follower or the like coupled to the transceiver unit travels.

In operation, an area of property that meets the space requirements for a transceiver station installation is leased from a property owner, the space is optimized by installing a track system of the present invention on the leased area, and one or more of a plurality of transceiver units are moveably mounted on the parallelly spaced tracks of the track system. The transceiver unit or units mounted on the tracks may advantageously be shifted laterally along the tracks to provide sufficient clearance for a technician to access the electronic components housed in the transceiver cabinets. Alternatively, the capacity of an existing installation may be increased by installing additional cabinets without having to increase the lease area. This may be accomplished by optimizing the existing installation space by installing the track system of the present invention and mounting one or more additional and/or existing transceiver units onto the track system.

Once installed on the track system, the cabinets may be shifted laterally to allow a technician the required clearance for working on the cabinets.

In an alternative embodiment, a modular containment cabinet and track system may be provided to meet individual transceiver installation site characteristics and requirements, and preferably minimize installation footprint and, thus, associated lease area. The track system preferably enables forward mounted cabinets, such as transceiver units, radio base stations and the like, battery back-up cabinets, air conditioner units and the like, to be shifted laterally, side to side, to provide access cabinets mounted in the rear of the containment cabinet. Further, the containment cabinet may advantageously be expanded by combining two or more modules. Alternatively, one or more cabinets housing radio, battery or AC equipment may be mounted on the doors of the containment cabinet and, as the doors are swung open, rotated out of the containment cabinet and out of interference with the lateral pathway of the remaining cabinets to enable them to be shifted laterally on the tracks of the track system.

In another alternative embodiment, a horizontal transceiver cabinet is provided that advantageously comprises horizontally disposed transceiver and battery back-up units. Use of the horizontal transceiver cabinet enables carriers to comply with strict planning restrictions in regard to visual impacts and still meet transmission capacity needs. Each transceiver and battery back-up unit is preferably suspended on individual track systems comprising rolling track rails received in guide rails, and can be easily pulled out for maintenance access. The horizontal transceiver cabinet, which is also modular, may advantageously be expanded by combining several modules.

Other aspects and features of the present invention will become apparent from consideration of the following description taken in conjunction with the accompanying drawings.

### BRIEF DESCRIPTION OF THE DRAWINGS

Figure 1 is an oblique view of a base transceiver station ("BTS") cabinet mounted on the tracks of a track system.
Figure 1A is an oblique view of first and second modular rack components.
Figure 2 is a detail view of the BTS cabinet and the track shown in Figure 1 and taken along line 2 in Figure 1.
Figures 3A and 3B are plan views of a first embodiment of a transceiver station installation incorporating the track system.
Figures 4A and 4B are plan views of a second embodiment of a transceiver station installation incorporating the track system.
Figure 5 is a front view of the BTS cabinet and rack system.
Figures 6A and 6B are detail views of the BTS cabinet and track shown in Figure 5 and taken along lines 6A and 6B in Figure 5.
Figure 7 is a side view of the BTS cabinet and rack system.
Figure 8 is a detail view of the BTS cabinet and track shown in Figure 7 and taken along line 8 in Figure 7.
Figure 9 is an oblique view of a modular containment cabinet and track system.
Figure 10 is a top view of the cabinet and track system shown in Figure 9 with the top panel removed.
Figure 11 is a front view of the cabinet and track system shown in Figure 9 with the front doors panel removed.
Figure 12 is a side view of the cabinet and track system shown in Figure 9 with the side panel removed.
Figure 13 is an oblique view of an expansion module to the cabinet and track system shown in
Figure 9.

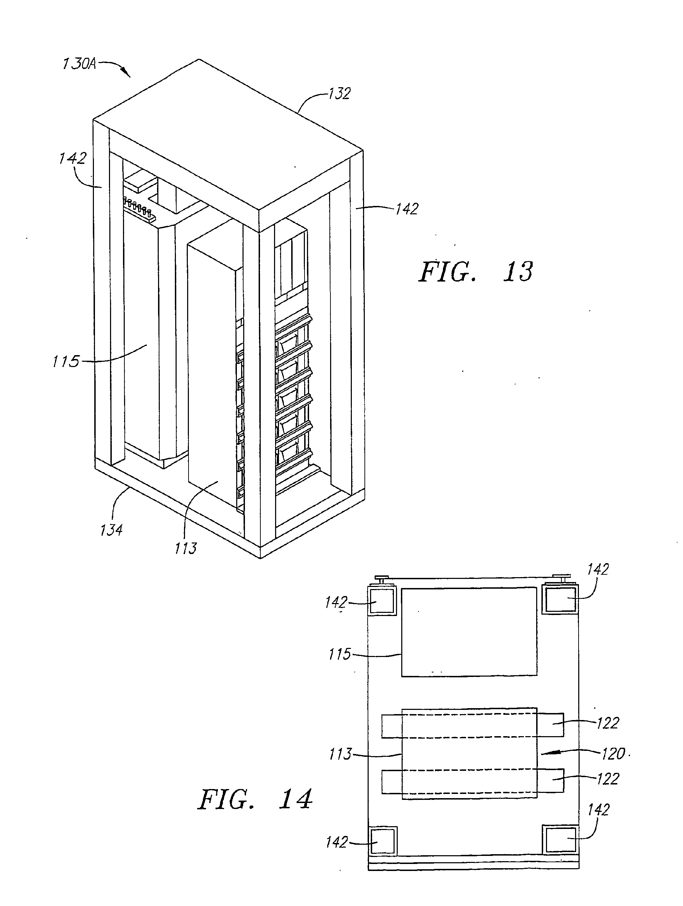

Figure 14 is a top view of the expansion module shown in Figure 13 with the top panel removed.

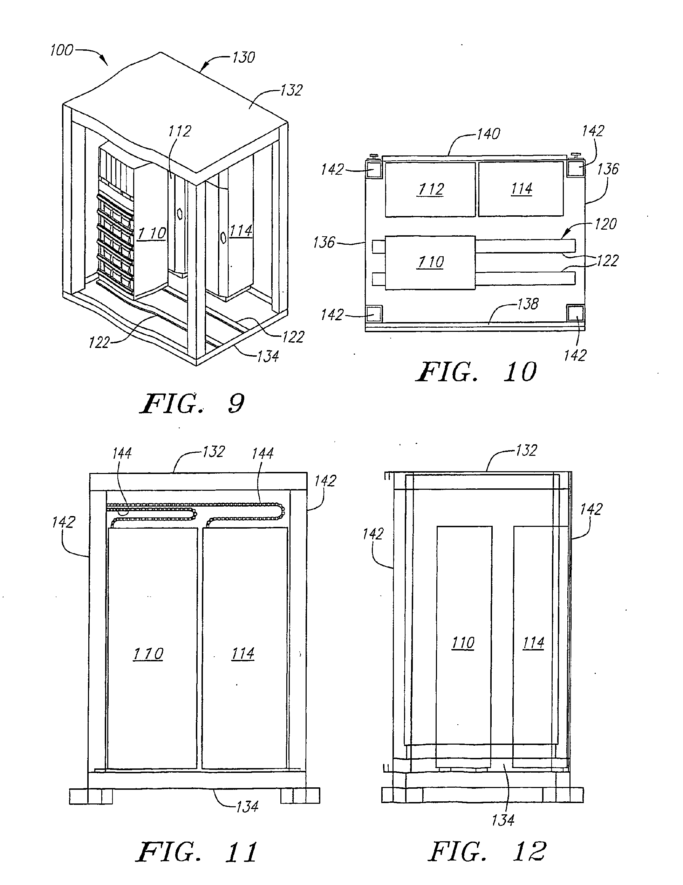

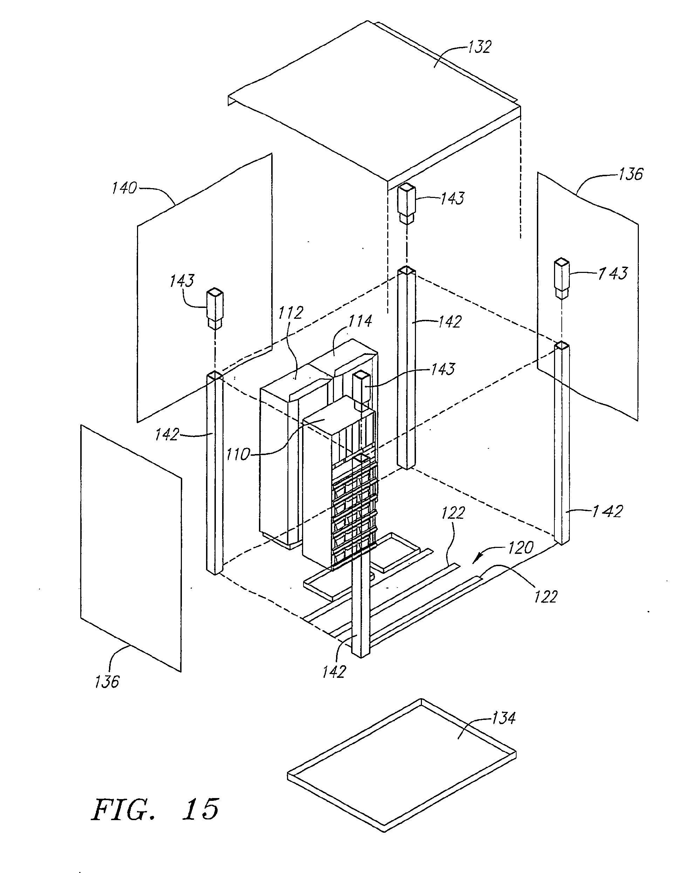

Figure 15 is an oblique exploded assembly view of the cabinet and track system shown in Figure 9.

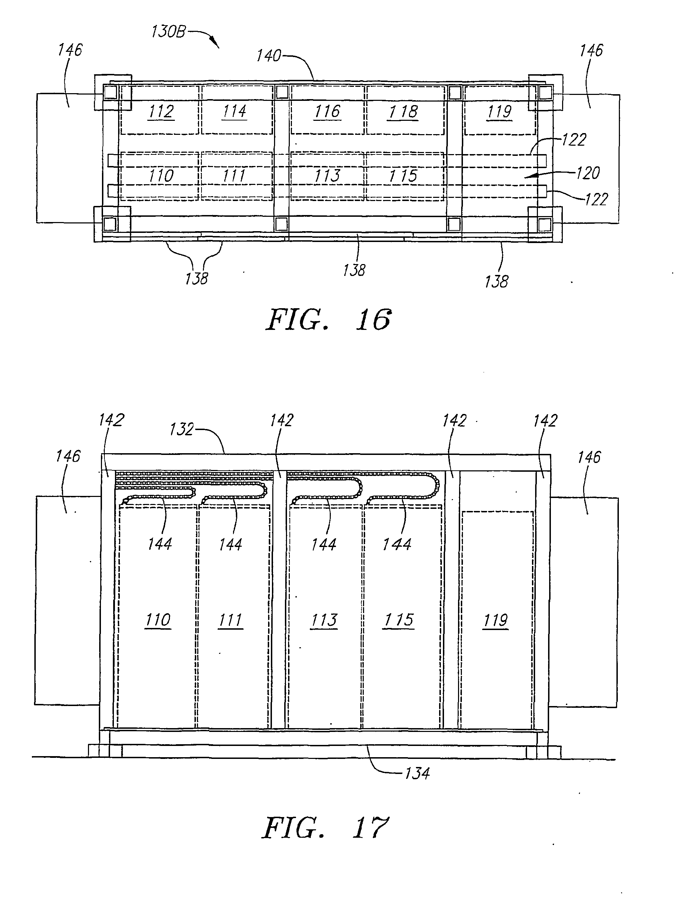

Figure 16 is a top view of the cabinet and track system of the present invention with connected expansion modules for use with nine transceiver and battery backup units.
Figure 17 is a front view of the cabinet and track system shown in Figure 16.

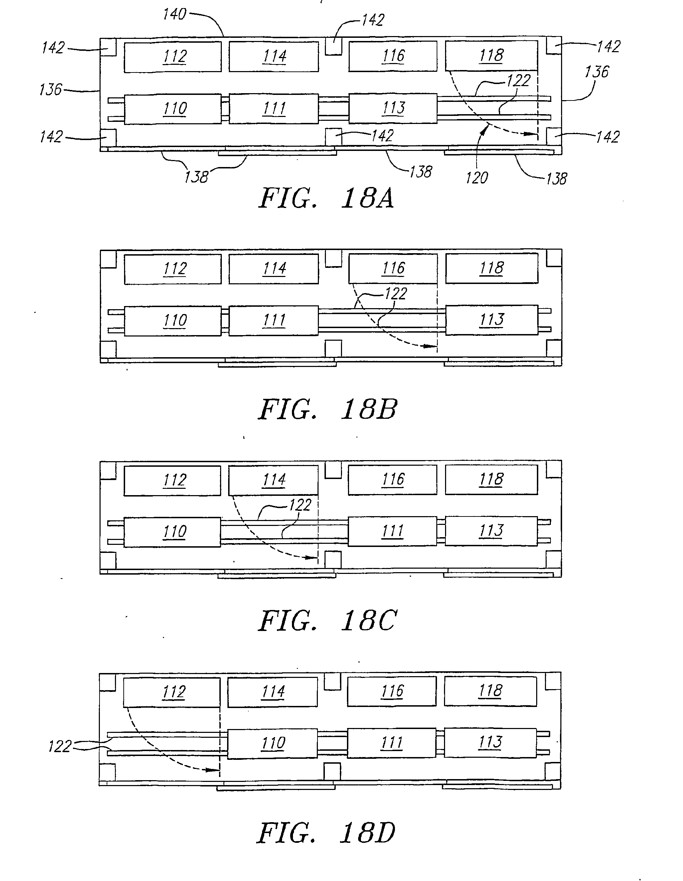

Figures 18A-18D are top views showing the operation of the track system in the cabinet and track system embodiment.

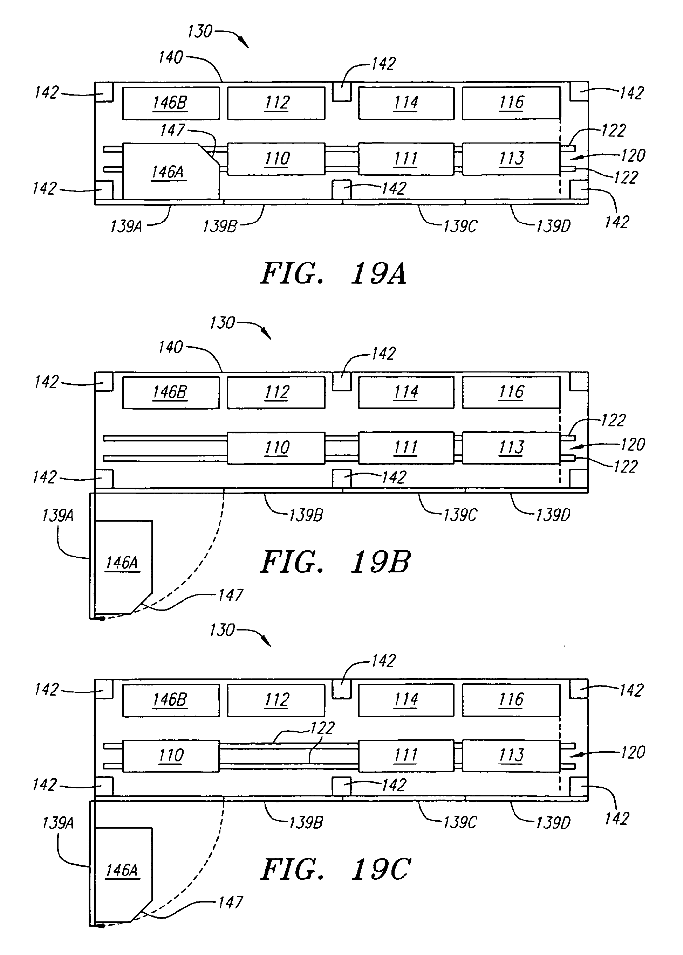

Figures 19A-19C are top views showing an alternate embodiment of the cabinet and track system and the operation thereof.

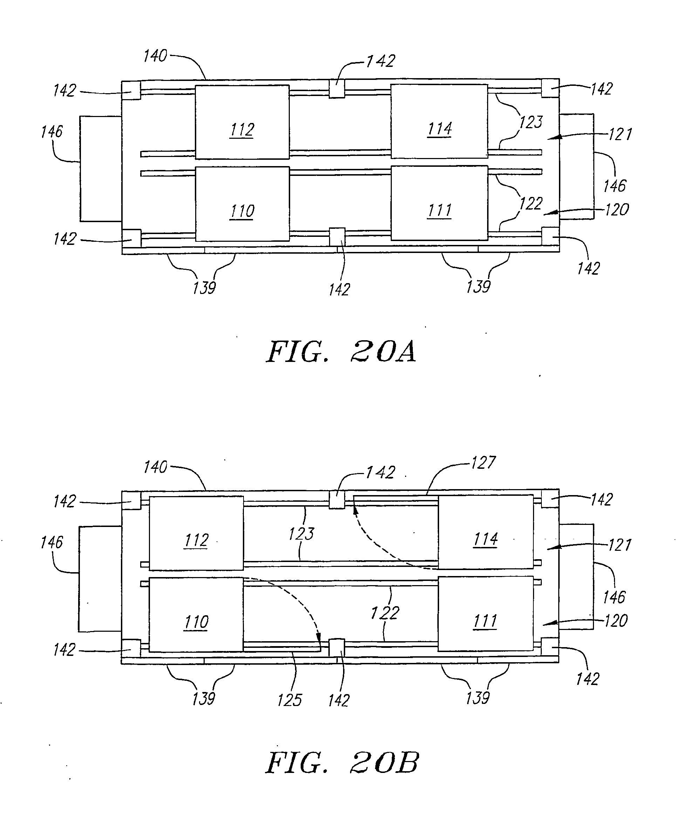

Figures 20A-20B are top views showing another alternate embodiment of the cabinet and track system and the operation thereof.

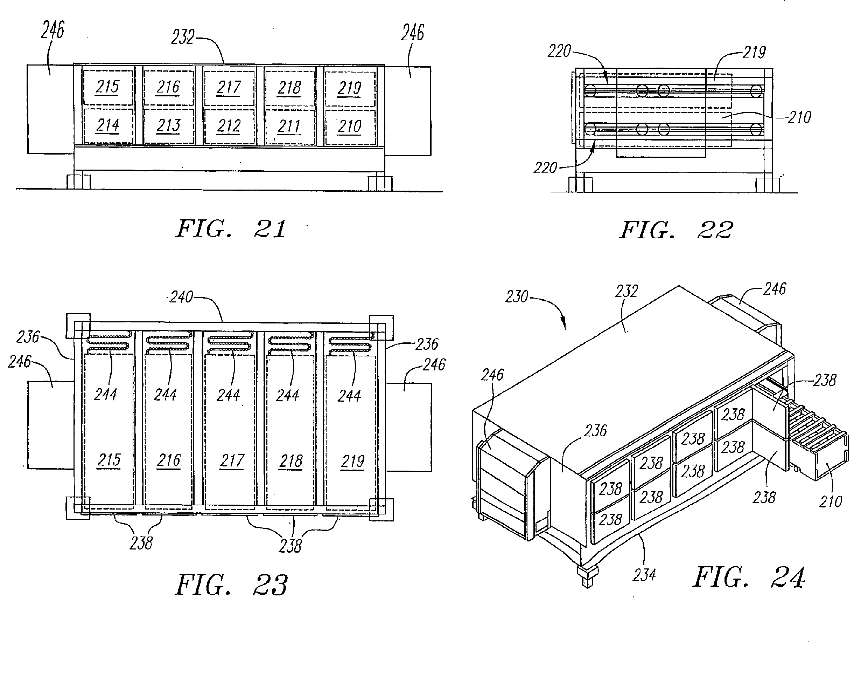

Figure 21 is a front view of a modular containment cabinet housing horizontally disposed transceiver and battery backup units.
Figure 22 is a side view of the cabinet shown in Figure 21.
Figure 23 is a top view of the cabinet shown in Figure 21.
Figure 24 is a oblique view of the cabinet shown in Figure 21.

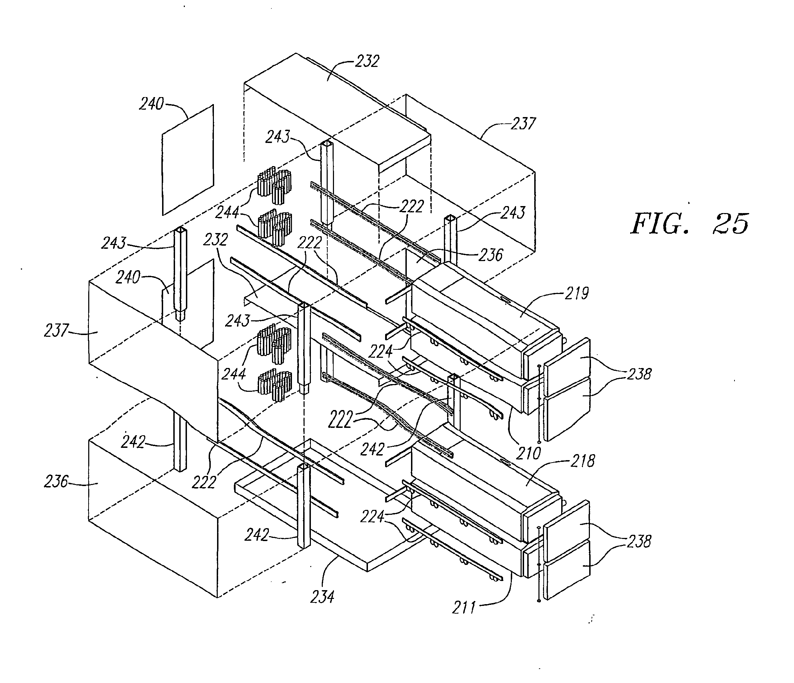

Figure 25 is an oblique exploded assembly view of the cabinet shown in Figure 21.

### DETAILED DESCRIPTION OF PREFERRED EMBODIMENTS

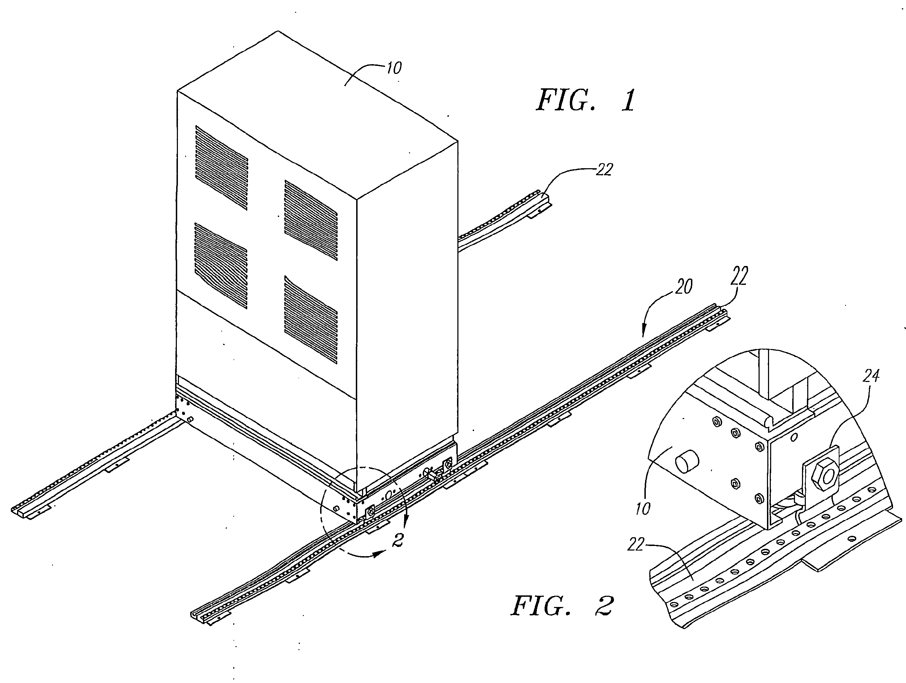

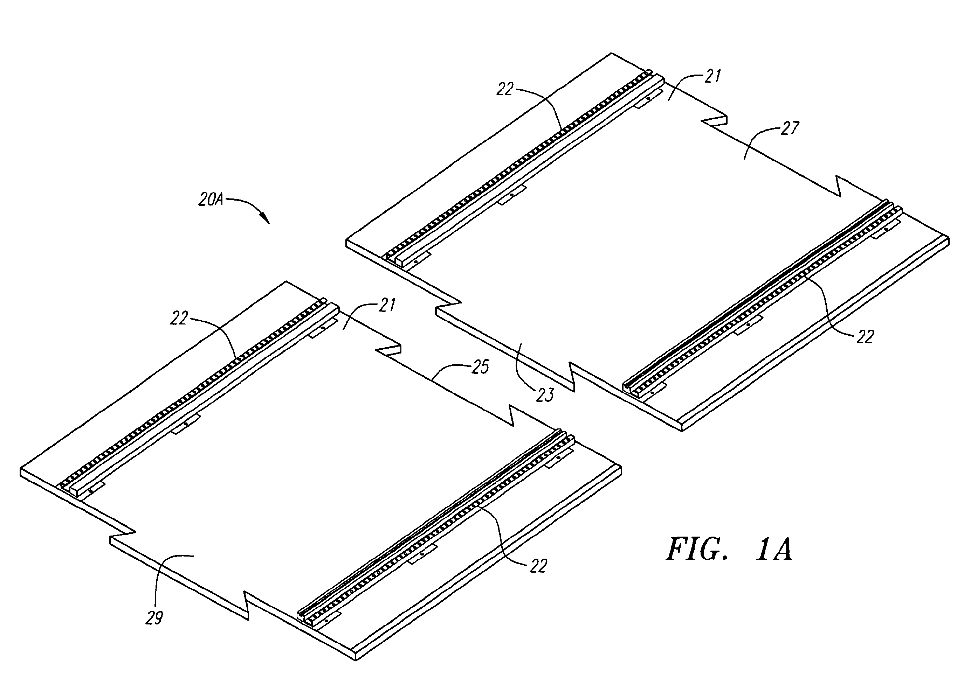

Referring to Figure 1, a cabinet 10, such as a base transceiver station (BTS), radio base station (RBS), electronic equipment cabinet or the like, is shown mounted on a track system 20

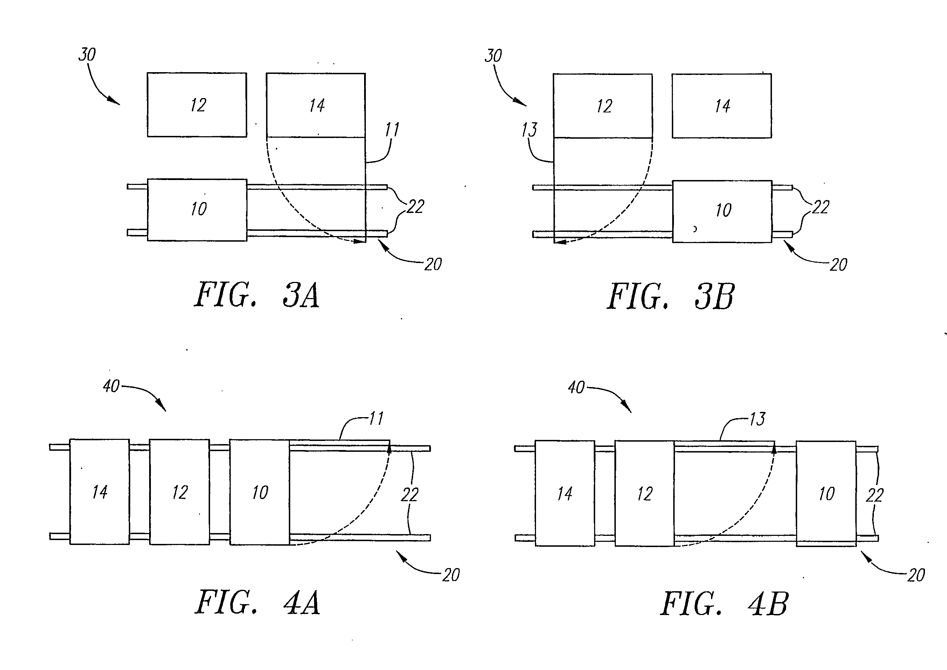

In a preferred embodiment, the track system 20 preferably comprises one or more sets of parallelly spaced tracks 22, preferably formed of steel, having a predetermined length and spacing to accommodate a desired cabinet installation configuration. As shown in Figures 3A-B and 4A-B, one or more of a plurality of BTS, transceiver, or other electronic equipment cabinets 10, 12, and 14 may be mounted on the tracks 22 side-to-side, front-to-front, back-to-back, and/or front-to-back, and laterally moveable along the tracks 22. As shown in Figure 1A, the tracks 22 may be mounted on a base 21 formed of steel or the like, to form a modular rack 27 and 29. Two or more of the modular racks 27 and 29 may be coupled together using a tongue 23 and groove 25 configuration, or some other means to align and couple the racks, to form a track system 20A of a desired configuration or size. Although shown on the ends of the racks 27 and 29, the aligning and coupling members 23 and 25 may be attacked or formed on the sides of the racks 27 and 29.

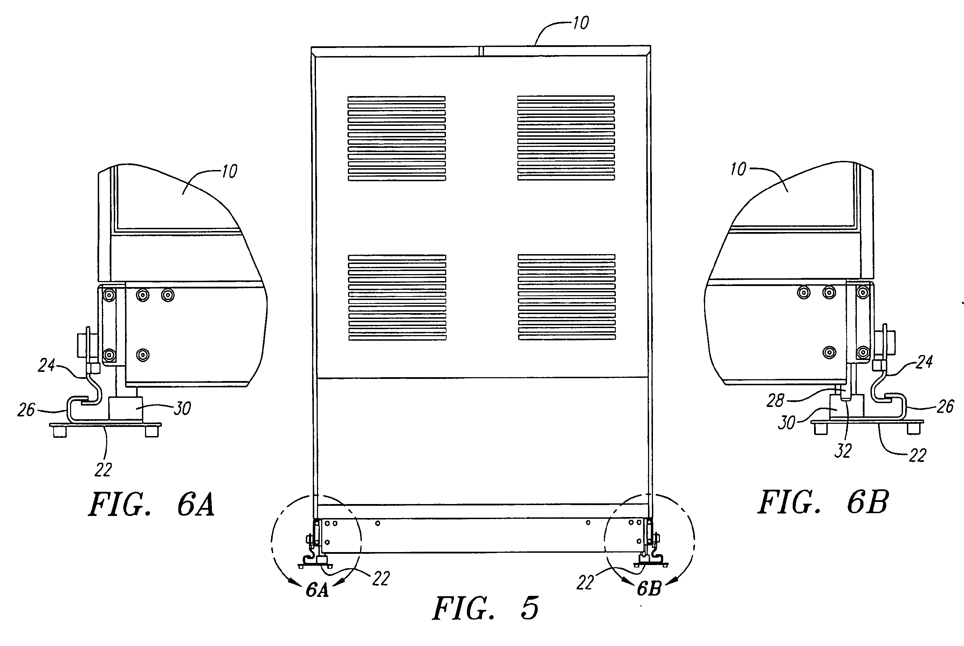

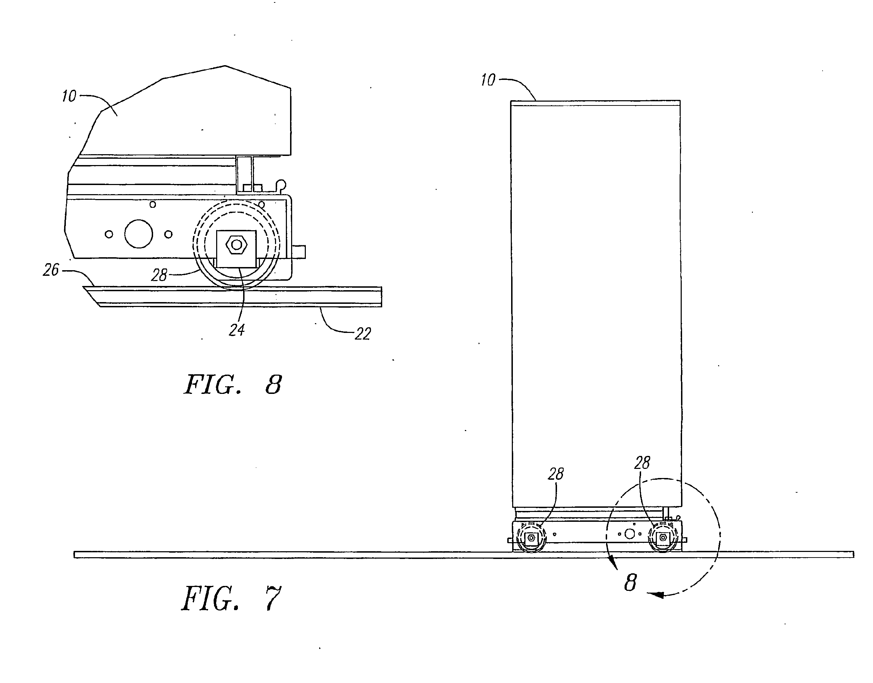

Referring to Figures 2 and 5 through 8, the tracks 22 preferably include a ramp (not shown) at their ends to enable a BTS or transceiver cabinet 10 to be installed on the tracks 22, a guide track 30 and an anti-tip track 26. The guide track 30 may be flat or may preferably include a wheel saddle, groove or the like 32, along which wheels 28, feet, slides, followers or the like coupled to the BTS or transceiver cabinet 10 travel. An anti-tip arm 24, follower or the like is preferably coupled to the cabinet 10 and adapted to slidably engage the anti-tip track 26 as the cabinet 10 travels along the tracks 22.

In operation, an area of property that meets the space requirements for a transceiver installation site, comprising one or more BTS or transceiver cabinets, is preferably leased from a property owner. Use of the space or transmission capacity for a transceiver installation on the space is preferably optimized by installing the track system 20 or 20A of the present invention on the leased area. Once the track system 20 or 20A is installed, one or more BTS or transceiver units 10, 12 and 14 may be moveably mounted on the parallelly spaced tracks 22 of the track system 20 as shown in Figures 3A-B and 4A-B. The BTS or transceiver units 10, 12 and 14 may advantageously be laterally shifted along the tracks 22 to provide sufficient clearance for a technician to open the cabinet doors 11 and 13 and access the electronic components housed in the BTS or transceiver cabinets 10, 12, and 14. As shown in Figures 3A and 3B, a moveable BTS or transceiver cabinet 10 is shifted laterally along the tracks 22 relative to stationary BTS or transceiver cabinets 12 and 14 to allow the technician to open the doors 11 and 13 of the cabinets 14 and 12, respectively. However, as shown in Figures 4A and 4B, each of the BTS or transceiver cabinets 10, 12 and 14 may be mounted on the tracks 22 and may be shifted laterally to create sufficient clearance to open the doors of one of the cabinets.

Alternatively, the transmission capacity of an existing installation site may be increased without increasing the associated lease area. Increasing the transmission capacity of the existing installation site maybe accomplished by optimizing the existing leased space by installing the track system 20 of the present invention on the leased space and, as shown in Figures 3A-B and 4A-B, mounting one or more of additional and/or existing BTS or transceiver units 10, 12 and 14 on the track system 20. Once installed on the track system, the BTS or transceiver cabinets 10, 12 and 14 may be moved laterally to allow a technician the required clearance for working on the cabinets 10, 12 and 14 and the electronics housed therein.

Turning to Figures 9 through 18, a modular containment cabinet and track system 130 of the present invention is shown that can be configured to meet installation site characteristics and requirements for individual transmission or transceiver stations. The containment cabinet and track system 130 preferably minimizes the installation footprint of the transmission station and, thus, minimizes the amount of associated lease area. The track system 120 of the containment cabinet 130 preferably enables forward mounted cabinets, which may include transceivers, radio base stations and the like, and battery back-up cabinets 110, 112, 114, etc., or cabinets housing other electronic equipment, air conditioning units, and the like, to be shifted laterally, side to side, to provide access to rear-mounted stationary cabinets 112 and 114.

For the same transmission capacity of traditional exterior self-contained cabinet installations, such as BTS installations, the containment cabinet and track system 130 of the present invention tends to require approximately 50% less lease area and tends to be 50% lighter when filled with transceiver and battery back-up cabinets 110, 112 and 114 resulting in lower lease and engineering costs for a carrier.

The containment cabinet 130 may be formed from a single quad module 130 as shown Figures 9 through 12, or by combining two or more bi modules 130A (as shown in Figures 13 and 14), quad modules or quad and bi modules. As depicted, the quad module 130, as a stand-alone module, preferably holds three cabinets 110, 112 and 114 for radio base stations (RBS), battery backup stations (BBS), or other equipment, wherein the moveable cabinet 110 may be shifted laterally along the tracks 122 relative to the stationary cabinets 112 and 114. The quad module can be easily reconfigured and mated with a bi module 130A (see Figures 13 and 14) to increase its cabinet 110, 112, 113, 114 and 115 capacity to five. An additional quad module can be added to increase cabinet capacity to nine. As depicted in Figures 16 and 17, a containment cabinet 130B comprising two quad modules and one bi module preferably holds nine cabinets 110, 111, 112, 113, 114, 115, 116, 118 and 119 wherein the moveable cabinets 110, 111, 113 and 115 may be shifted laterally along the tracks 122 relative to the stationary cabinets 112, 114, 116, 118 and 119.

Each module 130 preferably includes removable side 136 and rear 140 panels, a roof 132, sliding doors 138, a base 134 and a track system 130 mounted on and extending the full width of the base 134. The side and rear panels 136 and 140 preferably comprise lightweight composite panels that preferably slide in grooves formed in frame posts 142. Alternatively, the panels may be formed of steel or other materials capable of maintaining security and environmental protection. The side and rear panels 136 and 140 are preferably secured to the roof 132 with bolts or the like. As depicted in Figure 15, the height of the module may be easily increased with extension posts 143 to accommodate taller cabinets.

In a preferred embodiment, wheels that roll on horizontal tracks 122 are preferably coupled to the base of the forward-mounted cabinets 110, 111, 113 and 115. This advantageously allows the forward mounted cabinets to be shifted laterally for maintenance access to rear-mounted cabinets 112, 114, 116 and 118. Coaxial data and power cables are preferably routed to the moveable cabinets 110, 111, 113, 115, etc., using flexible cable tracks 144 such as KabelSchlepp's Plastitrak™, Versatrak™, Varitrak™, Profile™, Quantum™ or Conduflex™ hose and cable carrier products. Sliding front door panels 138 allow access while maintaining security and environmental protection. Environmental control systems 146 are depicted as mounted on the sides of the containment cabinet 130, but may be mounted within the containment cabinet. However, where environmental control or air conditioning equipment is internal housed in a moveable cabinet, air flow is preferably routed to the cabinet using flexible ducting.

In operation, the track system of the containment cabinet 130 allows maintenance access to rear mounted cabinets. As depicted in Figures 18A through 18D, access to a first rear mounted cabinet 118 is allowed by laterally shifting all moveable cabinets 110, 111 and 113 to the left and opening the door of the first rear mounted cabinet 118. Access to a second rear mounted cabinet 116 is allowed by shifting a first moveable cabinet 113 laterally to the right along the tracks 122 and, if not already shifted, shifting second and third moveable cabinets 111 and 110 to the left. Access to a third rear mounted cabinet 114 is allowed by shifting a second moveable cabinet 111 laterally to the right along the tracks 122 if the first moveable cabinet 113 is already shifted, or by shifting first and second moveable cabinets 113 and 111 to the right and, if not already shifted, shifting a third moveable cabinet 110 to the left. Access to a fourth rear mounted cabinet 112 is allowed by shifting a third moveable cabinet 110 laterally to the right along the tracks 122 if first and second moveable cabinets 113 and 111 are already shifted or by shifting all of the moveable cabinets 110, 111 and 113 to the right.

As an alternative, it may be desirable to further reduce the footprint of the containment cabinet 130 by mounting a cabinet housing RBS or BBS units, or other equipment such as an AC unit on a door of the containment cabinet 130. As depicted in Figures 19A, 19B and 19C, an environmental control or AC unit 146A is mounted on a first door 139A of the cabinet 130. A second AC unit is provided in a rear stationary cabinet 146B. With the first door 139A closed, the moveable cabinets 110, 111 and 113 mounted on the tracks 122 of the track system 120 can not, due to the interference by the door mounted cabinet 146A, be shifted laterally to provide access to the rear stationary cabinets 112, 114 and 116. By swinging open the door 139A, the door mounted cabinet 146A is also swung out of the containment cabinet 130 and out of interference with the lateral movement of the track mounted cabinets 110, 111 and 113. To assist in rotating the cabinet 146A out of the containment cabinet 130 or provide sufficient clearance therefore, it may be desirable to provide a cabinet with a chamfered internal corner 147 design. As discussed above, flexible cabling and ducting would be coupled to the cabinet 146A.

In operation, the door 139A with the mounted cabinet 146A is swung open and the mounted cabinet 146A is swung out of the containment cabinet 130 (see Figure 19B). As such, maintenance access to the rear stationary cabinet 146B adjacent the mounted cabinet 146A is provided. As depicted in Figure 19C, the first moveable cabinet 110 may be laterally shifted along the tracks 122 to the left to provide access to the adjacent rear stationary cabinet 112 when the second door 139B is opened. Access to the other rear stationary cabinets 114 and 116 can be provided by laterally shifting the other moveable cabinets 111 and 113 to the left along the tracks 122 and opening the other cabinet doors 139C and 139D.

As a further alternative, it may be desirable to provide a containment cabinet having a pair of track systems 120 and 121 to accommodate cabinets 110, 111, 112 and 114 as depicted in Figures 20A and 20B. As shown in Figure 20B, the cabinets 110, 111, 112 and 114 may be shifted to the outside along the tracks 122 and 123 to provide sufficient clearance to open their doors, e.g., doors 125 and 127 of cabinets 110 and 114 respectively, for maintenance access. Turning to Figures 21 through 25, a horizontal transceiver cabinet 230 is shown. The transceiver cabinet 230 includes RBS and BBS cabinets 210, 211, 212, 213, 214, 215, 216, 217, 218 and 219, or cabinets housing other electronic or environment control equipment advantageously horizontally disposed in pairs to minimize height. Use of the horizontal transceiver cabinet of the present invention tends to enable carriers to comply with strict planning restrictions in regard to visual impacts and still meet transmission capacity needs. Like the modular containment cabinet 130 described above, the transceiver cabinet tends to save approximately 50% on lease area and weight in relation to a typical BTS installation having the same transmission capacity. As shown in Figure 25, the transceiver cabinet 230 is a modular system formed from side and rear panels 236 and 240 slidably received in grooves formed in frame posts 242 and secured to a roof 232. The frame posts 242 are secured to a base 234. Each transceiver module preferably holds two cabinets (RBS or BBS), e.g., upper and lower cabinets 219 and 210, which are preferably suspended on individual track systems 220 comprising rolling track rails 224 received in guide rails 222, and can be easily pulled out for maintenance access after opening its individual door 238. Coaxial data and power cables preferably are routed using flexible cable tracks 244, as discussed above, extending to the back end of each cabinet. If desirable to stack two modules together, the height of the transceiver cabinet 230 can be easily increased by adding extension posts 243 and additional side and rear panels 237 and 240.

Environmental control for the containment cabinet 130 and horizontal transceiver cabinet 230 is accomplished using two air conditioning units 246 running lead lag. As a result, the environmental control system provides a weight, seize, maintenance, energy and cost savings over traditional exterior cabinet installations that utilize two air conditioners for each cabinet. Cool air is routed over each cabinet and is drawn through the cabinets by internal cabinet fans. Hot air exhaust from the cabinets is routed back to the AC units through a series of ducts to prevent mixing and promote energy efficiency.

The methods and apparatus described above facilitate the optimization of the leased area space for an antenna and transceiver installation site. The slidable rack system 20, 120 and 220 advantageously minimizes lease area space requirements to enable the installation of more transceiver units or cabinets in the same amount of space previously required for fewer BTS-type cabinets. As a result, the installation footprints can be custom designed to meet difficult space constraints. In addition, existing installation may be upgraded by adding transceiver units or other radio cabinets without increasing the associated leased area's space requirements and renegotiating the lease.

## Claims

1. An installation site for electronic equipment comprising
a track system (20) including one or more pairs of parallely spaced tracks (22);
a plurality of cabinets (10, 12, 14) mounted close together for receiving electronic equipment wherein at least one (10) of the plurality of cabinets is moveably mounted on the track system (20);
a flexible cable track (144) coupled to the at least one (10) of the plurality of cabinets
for routing data and power cables;
and wherein the at least one (10) of the plurality of cabinets (10,12,14) when shifted provides access to doors of the plurality of cabinets (10, 12, 14). cabinets.

2. The installation site of claim 1 wherein each of the plurality of cabinets (10, 12, 14) is moveably mounted on the track system(20).

3. The installation site of claim 1 or 2 wherein each of the tracks (22) comprise a ramp coupled to at least one end of each track.

4. The installation site of claim 3 wherein each of the tracks comprise
a guide track (30), and
an anti-tip track (26):

5. The installation site of claim 4 wherein the guide track (30) includes a saddle (32) extending the length of the guide track (30).

6. The installation site of claim 4 further comprising
a plurality of wheels coupled to the at least one of the plurality of cabinets (10, 12, 14) mounted on the track system (20) and operably coupled to the guide tracks(30),
and
a plurality of anti-tip arms (24) coupled to the cabinets (10) and operably coupled to the anti-tip tracks (26).

7. The installation site of claim 1 further comprising a containment cabinet (130) housing the plurality of cabinets (10, 12, 14) and the track system (20).

8. The installation site of claim 7 wherein the at least one of the plurality of cabinets (10, 12, 14) mounted on the track system (20) is shiftable to provide access to another one of the plurality of cabinets(10, 12, 14).

9. The installation site of claim 7 wherein the containment cabinet (130) is formed from a plurality of modules(130A).

10. The installation site of claim 9 wherein the containment cabinet (130) is extendable in width.

11. The installation site of claim 9 wherein the containment cabinet (130) is extendable in height.

12. The installation site of claim 9 wherein the containment cabinet (130) comprises a plurality of frame posts (142) forming a frame,
a bottom panel (134) coupled to the plurality of frame posts (142),
a top panel (132),
side and rear panels (136,140) coupled to the top panel (132) and frame, and
a door operably coupled to the frame.

13. The installation site of claim 7 wherein the cabinets are horizontally disposed.

14. The installation site of claim 7 further comprising an environmental control system to affect at least one environmental condition within the containment cabinet (130).

15. A method of increasing the capacity of an electronic equipment installation site without increasing the installation site footprint comprising the steps of
steps of installing a track system (20) on the installation site, the track system (20) including one or more pairs of parallely spaced tracks (22); moveably mounting at least one (10) of a plurality of cabinets (10,12,14) mounted close together for receiving electronic equipment on the track system (20);
coupling a flexible track (144) to the at least one (10) of the plurality of cabinets (10,12,14) that is moveably mounted on the track system(20) said flexible track for routing data and power cables to the at least one of the plurality of cabinets; and
shifting the at least one (10) of the plurality of cabinets (10,12,14) to provide access to doors of the plurality of cabinets (10,12,14).

16. The method of claim 17 further comprising the step of moveably mounting the remainder of the plurality of cabinets on the track system.

## Patentansprüche

1. Montageort für elektronische Geräte umfassend:
ein Schienensystem (20) mit einem oder mehreren Paaren parallel beabstandeter Schienen (22);
eine Vielzahl von dicht aneinander montierten Schränken (10, 12, 14) zur Aufnahme elektronischer Geräte, **dadurch gekennzeichnet, dass** mindestens einer (10) der Vielzahl von Schränken beweglich an dem Schienensystem (20) gehalten ist;
eine flexible Kabelbahn (144), die zur Führung von Daten- und Stromkabeln an mindestens einem (10) der Vielzahl von Schränken gehalten ist; und
**dadurch gekennzeichnet, dass** mindestens einer (10) der Vielzahl von Schränken (10, 12, 14) durch Verschieben Zugang zu Türen der Vielzahl von Schränken (10, 12, 14) herstellt.

2. Montageort nach Anspruch 1, **dadurch gekennzeichnet, dass** jeder der Vielzahl von Schränken (10, 12, 14) beweglich an dem Schienensystem (20) gehalten ist.

3. Montageort nach einem der Ansprüche 1 oder 2, **dadurch gekennzeichnet, dass** jede der Schienen (22) eine Rampe umfasst, die an mindestens einem Ende jeder Schiene gehalten ist.

4. Montageort nach Anspruch 3, **dadurch gekennzeichnet, dass** jede Schiene eine Führungsschiene (30) und eine Anti-Kippschiene (26) umfasst.

5. Montageort nach Anspruch 4, **dadurch gekennzeichnet, dass** die Führungsschiene (30) einen Sattel (32) aufweist, der sich über die Länge der Führungsschiene (30) erstreckt.

6. Montageort nach Anspruch 4, weiter umfassend:
eine Vielzahl von Rädern, die an den mindestens einen der Vielzahl von Schränken (10, 12, 14), die an dem Schienensystem (20) gehalten sind, gekoppelt und funktionsfähig mit den Führungsschienen (30) gekoppelt sind; und
eine Vielzahl von Anti-Kipparmen (24), die an die Schränke (10) gekoppelt und funktionsfähig mit den Anti-Kippschienen (26) gekoppelt sind.

7. Montageort nach Anspruch 1, weiter umfassend einen Einfassungsschrank (130), der die Vielzahl von Schränken (10, 12, 14) und das Schienensystem (20) umgibt.

8. Montageort nach Anspruch 7, **dadurch gekennzeichnet, dass** der mindestens eine der Vielzahl von Schränken (10, 12, 14), der an dem Schienensystem (20) gehalten ist, verschiebbar ist, um Zugang zu einem weiteren der Vielzahl von Schränken (10, 12, 14) herzustellen.

9. Montageort nach Anspruch 7, **dadurch gekennzeichnet, dass** der Einfassungsschrank (130) aus einer Vielzahl von Modulen (130A) gebildet ist.

10. Montageort nach Anspruch 9, **dadurch gekennzeichnet, dass** der Einfassungsschrank (130) in einer Breite erweiterbar ist.

11. Montageort nach Anspruch 9, **dadurch gekennzeichnet, dass** der Einfassungsschrank (130) in einer Höhe erweiterbar ist.

12. Montageort nach Anspruch 9, **dadurch gekennzeichnet, dass** der Einfassungsschrank (130) umfasst:
eine Vielzahl von Rahmenstangen (142), die einen Rahmen bilden,
eine Bodenplatte (134), die an der Vielzahl von Rahmenstangen (142) gehalten ist,
eine Deckplatte (132),
Seiten- und Rückblenden (136, 140), die an der Deckplatte (132) und dem Rahmen gehalten sind, und
eine Tür, die funktionsfähig an dem Rahmen gehalten ist.

13. Montageort nach Anspruch 7, **dadurch gekennzeichnet, dass** die Schränke horizontal angeordnet sind.

14. Montageort nach Anspruch 7, weiter umfassend ein Umgebungskontrollsystem, das mindestens eine Umgebungsbedingung innerhalb des Einfassungsschranks (130) beeinflusst.

15. Ein Verfahren zur Vergrößerung der Kapazität eines Montageortes für elektronische Geräte, ohne die Aufstellfläche des Montageortes zu vergrößern, umfassend die Schritte:
Montieren eines Schienensystems (20) an dem Montageort, wobei das Schienensystem (120) ein oder mehrere Paare parallel beabstandeter Schienen (22) beinhaltet;
bewegliches Montieren von mindestens einem (10) von einer Vielzahl dicht aneinander montierter Schränke (10, 12, 14) zur Aufnahme elektronischer Geräte auf dem Schienensystem (20);
Verbinden einer flexiblen Bahn (144) mit dem mindestens einen (10) aus der Vielzahl von Schränken (10, 12, 14), der beweglich auf dem Schienensystem (20) montiert ist, wobei die flexible Bahn zur Führung von Daten- und Stromkabeln zu dem mindestens einen aus der Vielzahl von Schränken dient; und
Verschieben des mindestens einen (10) aus der Vielzahl von Schränken (10, 12, 14), um Zugang zu Türen der Vielzahl von Schränken (10, 12, 14) herzustellen.

16. Verfahren nach Anspruch 15, weiter umfassend den Schritt, die übrigen aus der Vielzahl von Schränken bewegbar auf dem Schienensystem zu montieren.

## Revendications

1. Site d'installation pour du matériel électronique comportant
un système de rails (20) comprenant une ou plusieurs paires de rails espacés de manière parallèle (22) ;
une pluralité d'armoires (10, 12, 14) montées ensemble de manière proche pour recevoir du matériel électronique dans lequel au moins une armoire (10) de la pluralité d'armoires est montée de manière mobile sur le système de rails (20) ;
un rail pour câblage flexible (144) accouplé à ladite au moins une armoire (10) de la pluralité d'armoires pour acheminer des câbles de données et d'alimentation ;
et dans lequel ladite au moins une armoire (10) de la pluralité d'armoires (10, 12, 14) après avoir été déplacée donne accès à des portes de la pluralité d'armoires (10, 12, 14).

2. Site d'installation selon la revendication 1, dans lequel chaque armoire de la pluralité d'armoires (10, 12, 14) est montée de manière mobile sur le système de rails (20).

3. Site d'installation selon la revendication 1 ou la revendication 2, dans lequel chacun des rails (22) comporte une rampe accouplée à au moins une extrémité de chaque rail.

4. Site d'installation selon la revendication 3, dans lequel chacun des rails comporte
un rail de guidage (30), et
un rail antibasculement (26).

5. Site d'installation selon la revendication 4, dans lequel le rail de guidage (30) comprend un coulisseau (32) s'étendant sur la longueur du rail de guidage (30).

6. Site d'installation selon la revendication 4, comportant par ailleurs
une pluralité de roues accouplées à ladite au moins une armoire de la pluralité d'armoires (10, 12, 14) montée sur le système de rails (20) et accouplée de manière fonctionnelle aux rails de guidage (30), et
une pluralité de bras antibasculement (24) accouplés aux armoires (10) et accouplés de manière fonctionnelle aux rails antibasculement (26).

7. Site d'installation selon la revendication 1, comportant par ailleurs une armoire de confinement (130) logeant la pluralité d'armoires (10, 12, 14) et le système de rails (20).

8. Site d'installation selon la revendication 7, dans lequel ladite au moins une armoire de la pluralité d'armoires (10, 12, 14) montée sur le système de rails (20) est en mesure d'être déplacée pour donner accès à une autre armoire de la pluralité d'armoires (10, 12, 14).

9. Site d'installation selon la revendication 7, dans lequel l'armoire de confinement (130) est formée à partir d'une pluralité de modules (130A).

10. Site d'installation selon la revendication 9, dans lequel l'armoire de confinement (130) est en mesure de s'étendre dans le sens de la largeur.

11. Site d'installation selon la revendication 9, dans lequel l'armoire de confinement (130) est en mesure de s'étendre dans le sens de la hauteur.

12. Site d'installation selon la revendication 9, dans lequel l'armoire de confinement (130) comporte
une pluralité de montants de châssis (142) formant un châssis,
un panneau inférieur (134) accouplé à la pluralité de montants de châssis (142),
un panneau supérieur (132),
des panneaux latéraux et arrière (136, 140) accouplés au panneau supérieur (132) et au châssis, et
une porte accouplée de manière opérationnelle au châssis.

13. Site d'installation selon la revendication 7, dans lequel les armoires sont disposées à l'horizontale.

14. Site d'installation selon la revendication 7, comportant par ailleurs un système de contrôle de l'environnement concernant au moins une condition d'environnement à l'intérieur de l'armoire de confinement (130).

15. Procédé permettant d'augmenter la capacité d'un site d'installation de matériel électronique sans augmenter l'encombrement du site d'installation comportant les étapes consistant à
installer un système de rails (20) sur le site d'installation, le système de rails (20) comprenant une ou plusieurs paires de rails espacés de manière parallèle (22) ;
monter de manière mobile au moins une armoire (10) d'une pluralité d'armoires (10, 12, 14) montées ensemble de manière proche pour recevoir du matériel électronique sur le système de rails (20) ;
accoupler un rail flexible (144) à ladite au moins une armoire (10) de la pluralité d'armoires (10, 12, 14) qui est montée de manière mobile sur le système de rails (20), ledit rail flexible permettant d'acheminer des câbles de données et d'alimentation à ladite au moins une armoire de la pluralité d'armoires ; et
déplacer ladite au moins une armoire (10) de la pluralité d'armoires (10, 12, 14) pour donner accès à des portes de la pluralité d'armoires (10, 12, 14).

16. Procédé selon la revendication 15, comportant par ailleurs l'étape consistant à monter de manière mobile le reste de la pluralité d'armoires sur le système de rails.
